# EUROPÄISCHE PATENTSCHRIFT

(11) **EP 1 157 388 B1**
(45) Veröffentlichungstag und Bekanntmachung des Hinweises auf die Patenterteilung: **31.07.2002**
(21) Anmeldenummer: 00910516.4
(22) Anmeldetag: 01.02.2000
(51) Int. Cl.: G11C 11/15

(54) **SPEICHERZELLENANORDNUNG UND VERFAHREN ZU DEREN HERSTELLUNG**
STORAGE CELL ARRANGEMENT AND METHOD FOR PRODUCING THE SAME
ENSEMBLE DE CELLULES MEMOIRES ET SON PROCEDE DE PRODUCTION

(30) Priorität: 26.02.1999 DE 19908518
(43) Veröffentlichungstag der Anmeldung: 28.11.2001
(73) Patentinhaber: Infineon Technologies AG, 81669 München (DE)
(72) Erfinder: SCHWARZL, Siegfried, D-85579 Neubiberg (DE); SCHELER, Ulrich, D-81737 München (DE)
(74) Vertreter: Müller - Hoffmann & Partner
(86) Internationale Anmeldenummer: DE0000305
(87) Internationale Veröffentlichungsnummer: WO0052701

(56) Entgegenhaltungen:
- DE-A- 19 726 852
- US-A- 5 861 328
- HU Y Z ET AL: "Chemical-mechanical polishing as an enabling technology for giant magnetoresistance devices" THIN SOLID FILMS,CH,ELSEVIER-SEQUOIA S.A. LAUSANNE, Bd. 308-309, Nr. 1-4, 31. Oktober 1997 (1997-10-31), Seiten 555-561, XP004110335 ISSN: 0040-6090

## Beschreibung

Die Erfindung betrifft eine Speicherzellenanordnung mit einem magnetoresistiven Speicherelement sowie ein Verfahren zu deren Herstellung.

Als magnetoresistives Element, auch Magnetowiderstandselement genannt, wird in der Fachwelt eine Struktur verstanden, die mindestens zwei ferromagnetische Schichten und eine dazwischen angeordnete nichtmagnetische Schicht aufweist. Je nach Aufbau der Schichtstruktur wird dabei unterschieden zwischen GMR-Element, TMR-Element und CMR-Element (siehe S. Mengel, Technologieanalyse Magnetismus, Band 2, XMR-Technologien, Herausgeber VDI Technologiezentrum Physikalische Technologien, August 1997).

Der Begriff GMR-Element wird für Schichtstrukturen verwendet, die mindestens zwei ferromagnetische Schichten und eine dazwischen angeordnete nichtmagnetische, leitende Schicht aufweisen und den sogenannten GMR (giant magnetoresistance)- Effekt zeigen. Unter dem GMR-Effekt wird die Tatsache verstanden, daß der elektrische Widerstand des GMR-Elementes abhängig davon ist, ob die Magnetisierungen in den beiden ferromagnetischen Schichten parallel oder antiparallel ausgerichtet sind. Der GMR-Effekt ist im Vergleich zum sogenannten AMR (anisotropic magnetoresistance)-Effekt groß. Als AMR-Effekt wird die Tatsache verstanden, daß der Widerstand in magnetisierten Leitern parallel und senkrecht zur Magnetisierungsrichtung verschieden ist. Bei dem AMR-Effekt handelt es sich um einen Volumeneffekt, der in ferromagnetischen Einfachschichten auftritt.

Der Begriff TMR-Element wird in der Fachwelt für Tunneling Magnetoresistance Schichtstrukturen verwendet, die mindestens zwei ferromagnetische Schichten und eine dazwischen angeordnete isolierende, nichtmagnetische Schicht aufweisen. Die isolierende Schicht ist dabei so dünn, daß es zu einem Tunnelstrom zwischen den beiden ferromagnetischen Schichten kommt. Diese Schichtstrukturen zeigen ebenfalls einen magnetoresistiven Effekt, der durch einen spinpolarisierten Tunnelstrom durch die zwischen den beiden ferromagnetischen Schichten angeordnete isolierende, nichtmagnetische Schicht bewirkt wird. Auch in diesem Fall ist der elektrische Widerstand des TMR-Elementes abhängig davon, ob die Magnetisierungen in den beiden ferromagnetischen Schichten parallel oder antiparallel ausgerichtet sind. Die relative Widerstandsendung beträgt dabei etwa 6 bis ca. 40 Prozent.

Ein weiterer Magnetowiderstandseffekt, der wegen seiner Größe (relative Widerstandsänderung von 100 bis 400 Prozent bei Raumtemperatur) Colossal Magnetoresistance-Effekt (CMR-Effekt) genannt wird, erfordert wegen seiner hohen Koerzitivkräfte ein hohes Magnetfeld zum Umschalten zwischen den Magnetisierungszuständen.

Es ist vorgeschlagen worden, (siehe zum Beispiel D. D. Tang et al, IEDM 95, Seiten 997 bis 999, J. M. Daughton, Thin Solid Films, Bd. 216 (1992), Seiten 162 bis 168, Z. Wang et al, Journal of Magnetism and Magnetic Materials, Bd. 155 (1996), Seiten 161 bis 163) GMR-Elemente als Speicherelemente in einer Speicherzellenanordnung zu verwenden. Die Speicherelemente werden über Leseleitungen in Reihe verschaltet. Quer dazu verlaufen Wortleitungen, die sowohl gegenüber den Leseleitungen als auch gegenüber den Speicherelementen isoliert sind. An die Wortleitungen angelegte Signale verursachen durch den in der Wortleitung fließenden Strom ein Magnetfeld, das bei hinreichender Stärke die darunter befindlichen Speicherelemente beeinflußt. Zum Einschreiben von Information werden x/y-Leitungen verwendet, die sich an der zu beschreibenden Speicherzelle kreuzen. Sie werden mit Signalen beaufschlagt, die am Kreuzungspunkt ein für die Ummagnetisierung ausreichendes magnetisches Feld verursachen. Dabei wird die Magnetisierungsrichtung in der einen der beiden ferromagnetischen Schichten umgeschaltet. Die Magnetisierungsrichtung in der anderen der beiden ferromagnetischen Schichten bleibt dagegen unverändert. Das Festhalten der Magnetisierungsrichtung in der zuletzt genannten ferromagnetischen Schicht erfolgt durch eine benachbarte antiferromagnetische Schicht, die die Magnetisierungsrichtung festhält, oder dadurch, daß die Schaltschwelle für diese ferromagnetische Schicht durch anderes Material oder andere Dimensionierung, zum Beispiel die Schichtdicke, im Vergleich zu der zuerst genannten ferromagnetischen Schicht vergrößert wird.

In US 5 541 868 und US 5 477 482 sind ringförmige Speicherelemente vorgeschlagen worden, die auf dem GMR-Effekt beruhen. Ein Speicherelement umfaßt einen Stapel, der mindestens zwei ringförmige ferromagnetische Schichtelemente und ein nichtmagnetisches leitendes Schichtelement, das dazwischen angeordnet ist, aufweist und der zwischen zwei Leitungen geschaltet ist. Die ferromagnetischen Schichtelemente unterschieden sich in ihrer Materialzusammensetzung. Eines der ferromagnetischen Schichtelemente ist magnetisch hart, das andere magnetisch weicher. Zum Einschreiben der Information wird die Magnetisierungsrichtung in dem magnetisch weicheren Schichtelement umgeschaltet, während die Magnetisierungsrichtung in dem magnetisch härteren Schichtelement erhalten bleibt.

Aus DE-A-19 726 852 ist ein magnetoresistiver Speicher bekannt, der eine Vielzahl gestapelter Speicherzellen auf einem Halbleitersubstrat enthält. Jede Zelle weist einen Teil eines magnetischen Materials, eine Wartleitung und eine Meßleitung auf.

Für die Frage, ob Speicherzellenanordnungen mit magnetoresistiven Speicherelementen technologische Bedeutung erlangen werden, ist es unter anderem wesentlich, ob derartige Speicherzellenanordnungen im Rahmen einer Halbleiterprozeßtechnik herstellbar sind. Dieses Problem und mögliche Lösungen sind in der Literatur bisher nicht beschrieben worden.

Der Erfindung liegt das Problem zugrunde, eine Speicherzellenanordnung mit magnetoresistiven Speicherelementen und ein Verfahren zu deren Herstellung anzugeben, die im Rahmen einer Halbleiterprozeßtechnik herstellbar ist.

Dieses Problem wird gelöst durch eine Speicherzellenanordnung gemäß Anspruch 1 sowie ein Verfahren zu deren Herstellung gemäß Anspruch 7. Weitere Ausgestaltungen der Erfindung gehen aus den übrigen Ansprüchen hervor.

Die Speicherzellenanordnung umfaßt in einem Zellenfeld erste magnetoresistive Speicherelemente, die rasterförmig angeordnet sind und die jeweils zwischen einer ersten Leitung und einer zweiten Leitung angeordnet sind. Es sind eine Vielzahl erster Leitungen und zweiter Leitungen vorgesehen. In einer Peripherie sind mindestens eine erste Metallisierungsebene und eine zweite Metallisierungsebene vorgesehen, die über Kontakte elektrisch miteinander verbunden sind. Derartige Kontakte zwischen Metallisierungsebenen werden in der Fachwelt üblicherweise Vias oder Via-Verbindungen genannt. Die Kontakte sind zwischen der ersten Metallisierungsebene und der zweiten Metallisierungsebene angeordnet. Die ersten Leitungen und die erste Metallisierungsebene sind in ein und derselben Ebene angeordnet. Die zweiten Leitungen und die Kontakte sind ebenfalls in ein und derselben Ebene angeordnet. Daher können sowohl die ersten Leitungen und die erste Metallisierungsebene als auch die zweiten Leitungen und die Kontakte aus jeweils einer leitenden Schicht durch entsprechende Strukturierung hergestellt werden.

Da die ersten Leitungen in derselben Ebene wie die erste Metallisierungsebene und die zweiten Leitungen in derselben Ebene wie die Kontakte angeordnet sind, ist der vertikale Abstand zwischen den ersten Leitungen und den zweiten Leitungen unabhängig von dem vertikalen Abstand zwischen der ersten Metallisierungsebene und der zweiten Metallisierungsebene einstellbar. Das hat den Vorteil, daß dieser Abstand zwischen den ersten Leitungen und den zweiten Leitungen auf die Gegebenheiten im Zellenfeld eingestellt werden kann, ohne Auswirkungen auf die Gegebenheit in der Peripherie.

Wie im Zusammenhang mit dem Stand der Technik beschrieben, erfolgt das Einschreiben von Information in eines der magnetoresistiven Speicherelemente durch Anlegen eines Magnetfeldes. Das Magnetfeld wird durch einen Strom induziert, der durch die zugehörige erste und zweite Leitung fließt. Da die Größe des Magnetfelds von der Stromstärke des fließenden Stroms und vom Abstand zu dem stromdurchflossenen Leiter abhängt, wobei in das Magnetfeld mit steigender Stromstärke ansteigt, mit steigendem Abstand abfällt, ist es wünschenswert, die ersten Leitungen und die zweiten Leitungen in der Nähe der magnetoresistiven Speicherelemente anzuordnen. Darüber hinaus ist es vorteilhaft, die magnetoresistiven Speicherelemente jeweils zwischen zwei Leitungen zu schalten, da dann über diese Leitungen zusätzlich der Widerstand des magnetoresistiven Speicherelementes, der der gespeicherten Information entspricht, bewertet werden kann. Bedingt durch die Dicke der magnetoresistiven Speicherelemente ist im Zellenfeld ein Abstand zwischen übereinander angeordneten ersten Leitungen und zweiten Leitungen von maximal 20 bis 40 nm anzustreben.

Der Vertikalabstand zwischen der ersten Metallisierungsebene und der zweiten Metallisierungsebene in der Peripherie muß hingegen zur Reduzierung parasitärer Kapazitäten zwischen der ersten Metallisierungsebene und der zweiten Metallisierungsebene und aus prozeßtechnischen Gründen wesentlich größer sein. Bei einer 0,35 µm-Technologie beträgt er typischerweise 350 bis 400 nm.

Durch Vorsehen der ersten Leitungen in derselben Ebene wie die erste Metallisierungsebene und der zweiten Leitungen in derselben Ebene wie die Kontakte kann somit im Zellenfeld zwischen den ersten Leitungen und den zweiten Leitungen ein anderer Abstand eingestellt werden als in der Peripherie zwischen der ersten Metallisierungsebene und der zweiten Metallisierungsebene, so daß der im Zellenfeld im Hinblick auf geringe Stromstärken zum Einschreiben der Information durch Änderung des Magnetisierungszustandes des magnetoresistiven Elementes erforderliche geringe Abstand einstellbar ist, während in der Peripherie der bezüglich parasitärer Kapazität und Technologie erforderliche um etwa eine Größenordnung größere Vertikalabstand zwischen den Metallisierungsebenen eingehalten werden kann. Gleichzeitig sind die ersten Leitungen und die zweiten Leitungen gemeinsam mit Strukturen in der Peripherie herstellbar. Für die Herstellung der ersten Leitungen und der zweiten Leitungen sind somit keine zusätzlichen Abscheideschritte, Lithographie und Strukturierungsschritte erforderlich. Dadurch vereinfacht sich die Herstellung der Speicherzellenanordnung.

Vorzugsweise weisen die ersten Leitungen und die erste Metallisierungsebene im wesentlichen dieselbe Dicke auf. Die zweiten Leitungen und die Kontakte sind von einem Intermetalldielektrikum umgeben und schließen im wesentlichen in derselben Höhe mit dem Intermetalldielektrikum ab. Diese Ausgestaltung der Erfindung weist eine planare Oberfläche auf, die im Hinblick auf die weitere Prozessierung vorteilhaft ist und mit abnehmenden Strukturgrößen an Bedeutung gewinnt.

Gemäß einer weiteren Ausgestaltung der Erfindung sind im Zellenfeld dritte Leitungen vorgesehen, die oberhalb der zweiten Leitungen angeordnet sind. Zwischen den zweiten Leitungen und den dritten Leitungen sind zweite magnetoresistive Speicherelemente angeordnet, wobei wieder jeweils einer der zweiten Leitungen und einer der dritten Leitungen eines der zweiten magnetoresistiven Speicherelemente zugeordnet ist. Die dritten Leitungen sind in derselben Ebene wie die zweite Metallisierungsebene in der Peripherie angeordnet. In dieser Ausgestaltung der Erfindung wird im Zellenfeld eine höhere Packungsdichte der Speicherelemente erzielt, da diese in zwei Ebenen übereinander angeordnet sind. Der Flächenbedarf pro Speicherelement sinkt somit um einen Faktor 2. Im Hinblick auf eine vereinfachte Ansteuerung des Zellenfeldes ist es dabei vorteilhaft, die ersten magnetoresistiven Speicherelemente und die zweiten magnetoresistiven Speicherelemente aus dem gleichen Material und mit denselben Eigenschaften vorzusehen. Die Eigenschaften der ersten magnetoresistiven Speicherelemente und der zweiten magnetoresistiven Speicherelemente können sich jedoch auch unterscheiden, falls deren Anwendung dieses erfordert.

Es ist darüber hinaus möglich, daß die Speicherzellenanordnung weitere Ebenen mit magnetoresistiven Elementen und darüber angeordneten Leitungen aufweist, so daß eine dreidimensionale Anordnung der magnetoresistiven Speicherzellen mit hoher Packungsdichte erzielt wird. Die ungeradzahligen Ebenen werden dabei analog wie die ersten Leitungen, die ersten magnetoresistiven Elemente und die zweiten Leitungen, die geradzahligen Ebenen analog den zweiten Leitungen, zweiten magnetoresistiven Elementen und den dritten Leitungen aufgebaut.

Im Hinblick auf die Planarität der Anordnung ist es vorteilhaft, die dritten Leitungen und die zweite Metallisierungsebene im wesentlichen mit derselben Dicke vorzusehen.

Zur Herstellung der Speicherzellenanordnung werden die dritten Leitungen und die zweite Metallisierungsebene vorzugsweise durch Abscheidung und Strukturierung einer gemeinsamen leitenden Schicht gebildet.

Zur Realisierung der Speicherzellenanordnung mit hoher Planarität ist es vorteilhaft, die leitenden Schichten, aus denen die ersten Leitungen und die erste Metallisierungsebene, die zweiten Leitungen und die Kontakte bzw. die dritten Leitungen und die zweite Metallisierungsebene durch Strukturierung gebildet werden, durch planarisierende Strukturierungsverfahren herzustellen. Dazu eignet sich insbesondere die Abscheidung isolierender Schichten, in denen Gräben der Form der später herzustellenden leitenden Strukturen erzeugt werden, und das Auffüllen der Gräben. Alternativ können die leitenden Strukturen durch Strukturierung einer leitenden Schicht unter Einsatz von Lithographie und Ätzverfahren gebildet werden, die nachfolgend mit isolierendem Material umgeben werden, das durch Abscheidung und Planarisierung, zum Beispiel durch chemisch mechanisches Polieren, strukturiert wird.

Die magnetoresistiven Speicherelemente weisen jeweils eine erste ferromagnetische Schicht, eine nichtmagnetische Schicht und eine zweite ferromagnetische Schicht auf, wobei die nichtmagnetische Schicht zwischen der ersten ferromagnetischen Schicht und der zweiten ferromagnetischen Schicht angeordnet ist. Die magnetoresistiven Speicherelemente können sowohl auf dem GMR-Effekt als auch auf dem TMR-Effekt beruhen. Die Verwendung magnetoresistiver Speicherelemente, die auf dem TMR-Effekt beruhen, wird wegen der im Vergleich zu dem GMR-Effekt größeren relativen Widerstandsänderung bevorzugt. Außerdem ist der höhere Widerstand der TMR-Elemente hinsichtlich eines geringeren Leistungsverbrauchs günstiger. Darüber hinaus können die magnetoresistiven Speicherelemente auf dem CMR-Effekt beruhen, falls die Anordnung die für das Umschalten hoher Magnetfelder erforderlichen Ströme verkraftet.

Die erste ferromagnetische Schicht und die zweite ferromagnetische Schicht enthalten vorzugsweise mindestens eines der Elemente Fe, Ni, Co, Cr, Mn, Gd, Dy und weisen eine Dicke zwischen 2 nm und 20 nm auf. Die erste ferromagnetische Schicht und die zweite ferromagnetische Schicht unterscheiden sich bezüglich der magnetischen Härte und/oder ihrer geometrischen Abmessungen.

Die nichtmagnetische Schicht enthält im Fall des TMR-Effektes mindestens eines der Materialien Al₂O₃, NiO, HfO₂, TiO₂, NbO, SiO₂ und weist eine Dicke zwischen 1 nm und 4 nm auf. Im Fall des GMR-Effektes enthält die nichtmagnetische Schicht mindestens einen der Stoffe Cu, Au, Ag und/oder Al und weist eine Dicke zwischen 2 nm und 5 nm auf.

Parallel zu den Leitungsebenen weisen die magnetoresistiven Speicherelementen einen beliebigen Querschnitt auf. Der Querschnitt kann insbesondere rechteckig, rund, oval, mehreckig oder ringförmig sein.

Zur Vermeidung von Diffusion zwischen den magnetoresistiven Speicherelementen und benachbarten Leitungen bei der Herstellung und/oder dem Betrieb der Speicherzellenanordnung ist es vorteilhaft, zwischen den magnetoresistiven Speicherelementen und benachbarten Leitungen jeweils eine Diffusionsbarriere vorzusehen. Dieser Effekt ist besonders wichtig, falls die Leitungen im Zellenfeld Cu, Ag oder Au enthalten.

Die Leitungen können alternativ oder zusätzlich Wolfram oder Metallsilizid enthalten.

Im folgenden werden Ausführungsbeispiele der Erfindung, die in den Figuren dargestellt sind, näher erläutert.
- Figur 1: zeigt eine Aufsicht auf eine Speicherzellenanordnung an der Schnittstelle von Speicherzellenfeld und Peripherie.
- Figur 2: zeigt den in Figur 1 mit II-II bezeichneten Schnitt durch die Speicherzellenanordnung.
- Figur 3: zeigt einen Schnitt durch eine Speicherzellenanordnung, die in zwei übereinander angeordneten Ebenen magnetoresistive Speicherelemente aufweist, an der Schnittstelle von Speicherzellenfeld und Peripherie.
- Die Figuren 4 bis 10: zeigen Schritte zur Herstellung einer Speicherzellenanordnung.
- Figur 11: zeigt eine perspektivische Ansicht einer Speicherzellenanordnung.

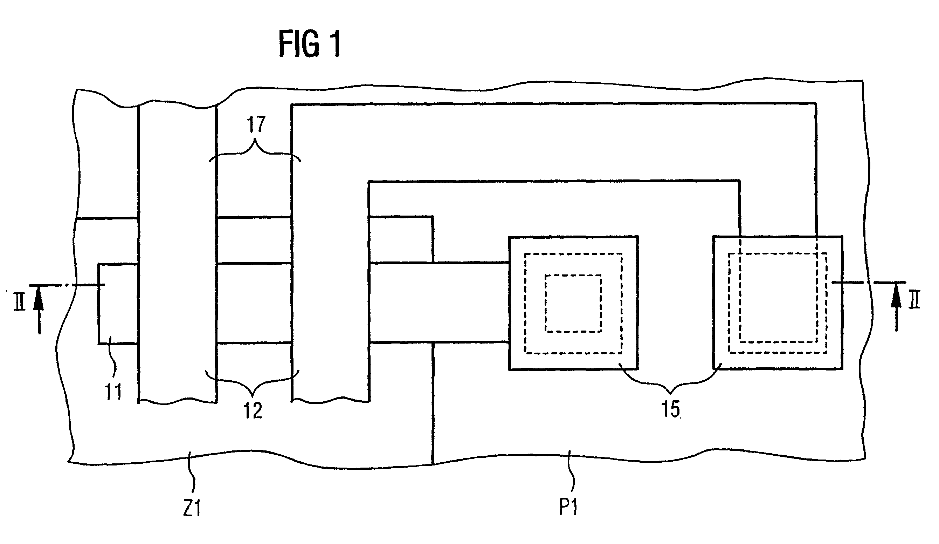

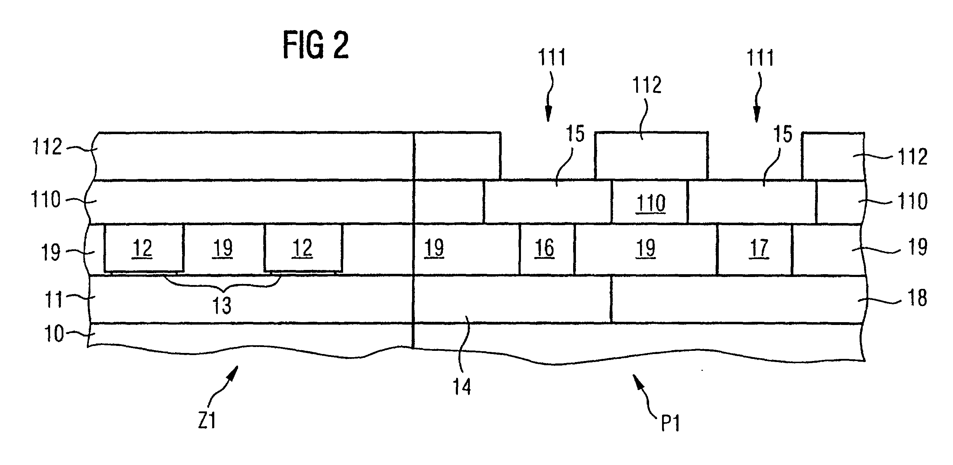

Eine Speicherzellenanordnung weist ein Zellenfeld Z1 und eine Peripherie P1 auf (siehe Figur 1 und Figur 2). Der Bereich des Zellenfeldes Z1 und der Peripherie P1 ist in Figur 2 durch eine senkrechte, durchgezogene Linie voneinander getrennt. In dem Zellenfeld Z1 sind erste Leitungen 11 und zweite Leitungen 12 angeordnet. Die ersten Leitungen 11 sind an der Oberfläche eines Halbleitersubstrats 10 angeordnet. Das Halbleitersubstrat 10 weist monokristallines Silizium auf und enthält im Bereich der Peripherie P1 und/oder unter dem Zellenfeld Bauelemente, die zur Ansteuerung des Zellenfeldes Z1 erforderlich sind.

Die ersten Leitungen 11 und die zweiten Leitungen 12 kreuzen einander. Im Kreuzungsbereich einer der ersten Leitungen 11 (aus Übersichtlichkeitsgründen ist in Figur 1 und Figur 2 nur eine erste Leitung 11 dargestellt) mit einer der zweiten Leitungen 12 ist jeweils ein magnetoresistives Element 13 angeordnet.

In der Peripherie P1 sind eine erste Metallisierungsebene 14 und eine zweite Metallisierungsebene 15 angeordnet. Die zweite Metallisierungsebene 15 ist oberhalb der ersten Metallisierungsebene 14 angeordnet und ist über Kontakte 16 elektrisch mit der ersten Metallisierungsebene 14 verbunden (der Übersichtlichkeit halber ist in Figur 2 nur ein Kontakt 16 eingezeichnet). In der Peripherie P1 sind ferner Anschlußleitungen 17 angeordnet, die mit den zweiten Leitungen 12 im Zellenfeld Z1 verbunden sind.

Die erste Metallisierungsebene 14 ist in ein und derselben Ebene wie die ersten Leitungen 11 angeordnet. Somit ist auch die erste Metallisierungsebene 14 an der Oberfläche des Halbleitersubstrats 10 angeordnet. Die ersten Leitungen 11 und die erste Metallisierungsebene 14 sind in eine erste Isolationsstruktur 18 eingebettet, mit der sie eine planare Oberfläche bilden. Die zweiten Leitungen 12, die Kontakte 16 und die Anschlußleitungen 17 sind in einer Ebene oberhalb der ersten Leitungen 11, der ersten Metallisierungsebene 14 und der ersten Isolationsstruktur 18 angeordnet. Die magnetoresistiven Speicherelemente 13, die zweiten Leitungen 12, die Kontakte 16 und die Anschlußleitungen 17 sind von einer zweiten Isolationsstruktur 19 umgeben, mit der die zweiten Leitungen 12, die Kontakt 16 und die Anschlußleitungen 17 eine planare Oberfläche bilden.

Oberhalb davon ist die zweite Metallisierungsebene 15 angeordnet, die von einer dritten Isolationsstruktur 110 umgeben ist, mit der sie eine ebene Oberfläche bildet.

Sowohl die ersten Leitungen 11 als auch die zweiten Leitungen 12 sind über die zweite Metallisierungsebene 15 kontaktierbar. Zum einen sind die ersten Leitungen 11 mit der ersten Metallisierungsebene 14 verbunden, die über Kontakte 16 mit der zweiten Metallisierungsebene 15 verbunden ist, zum anderen sind die zweiten Leitungen 12 über die Anschlußleitungen 17 mit der zweiten Metallisierungsebene verbunden. Die Kontaktierung der zweiten Metallisierungsebene 15 erfolgt über Kontaktlöcher 111 in einer Passivierungsschicht 112 aus SiO₂ oder SiO₂ und Si₃N₄. Die erste Isolationsstruktur 18, die zweite Isolationsstruktur 19 und die dritte Isolationsstruktur 110 bestehen aus einem für Intermetalldielektrika geeigneten Material, insbesondere SiO₂, Si₃N₄, organischen oder porösen anorganischen Dielektrika. Der vertikale Abstand zwischen den ersten Leitungen und den zweiten Leitungen 12 entspricht der Dicke der magnetoresistiven Speicherelemente 13 und beträgt 20 bis 30 nm. Der Abstand zwischen der ersten Metallisierungsebene 14 und der zweiten Metallisierungsebene 15 entspricht der Höhe der Kontakte 16 und beträgt 350 bis 400 µm.

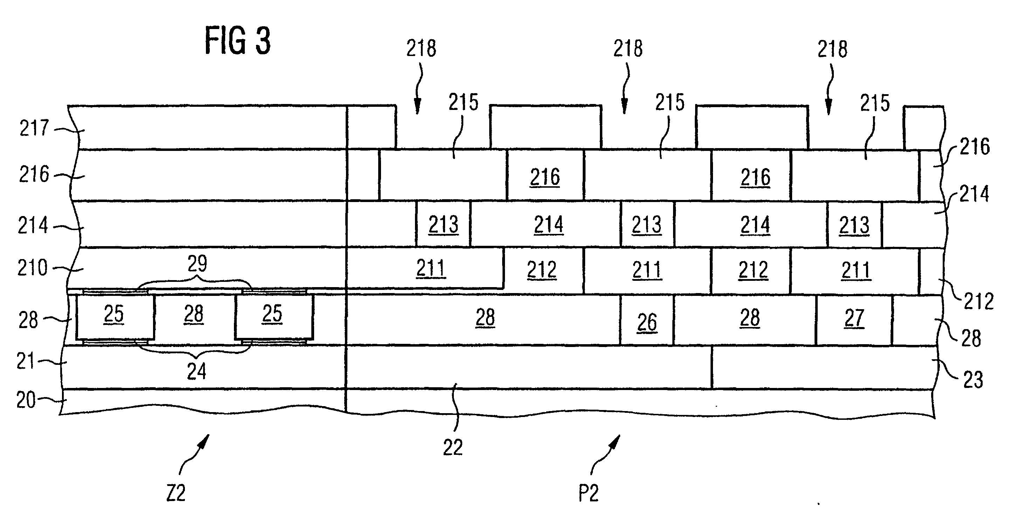

An der Oberfläche eines Halbleitersubstrats 20, das monokristallines Silizium enthält, sind in einem Zellenfeld Z2 erste Leitungen 21 und in einer Peripherie P2 eine erste Metallisierungsebene 22 angeordnet (siehe Figur 3, in der das Zellenfeld Z2 und die Peripherie P2 durch eine senkrechte, durchgezogene Linie voneinander getrennt sind). Die ersten Leitungen 21 sind mit der ersten Metallisierungsebene 22 verbunden. Die ersten Leitungen 21 und die erste Metallisierungsebene 22 sind von einer ersten Isolationsstruktur 23 umgeben, mit der sie eine ebene Oberfläche aufweisen.

An der Oberfläche der ersten Leitungen 21 sind erste magnetoresistive Speicherelemente 24 angeordnet, oberhalb denen zweite Leitungen 25 angeordnet sind. Die zweiten Leitungen 25 kreuzen die ersten Leitungen 21. In der Peripherie P2 sind in derselben Ebene wie die zweiten Leitungen 25 im Zellenfeld Z2 erste Kontakte 26 und Anschlußleitungen 27 angeordnet. Die Anschlußleitungen 27 sind mit den zweiten Leitungen 25 im Zellenfeld Z2 verbunden (außerhalb der in Figur 3 dargestellten Zeichenebene). Die zweiten Leitungen 25, die ersten Kontakte 26 und die Anschlußleitungen 27 werden durch Strukturierung einer leitenden Schicht aus Al, Cu, W, Siliziden gebildet und sind von einer zweiten Isolationsstruktur 28 umgeben, mit der sie in der Höhe abschließen.

Im Zellenfeld Z2 sind an der Oberfläche der zweiten Leitungen 25 zweite magnetoresistive Speicherelemente 29 angeordnet, die bezüglich geometrischer Form und Materialzusammensetzung mit den ersten magnetoresistiven Speicherelementen 24 übereinstimmen. Oberhalb der zweiten magnetoresistiven Speicherelemente 29 sind dritte Leitungen 210 im Zellenfeld Z2 angeordnet, die mit den zweiten magnetoresistiven Speicherelementen 29 in Verbindung stehen. In der Peripherie P2 ist in der Ebene der dritten Leitungen 210 eine zweite Metallisierungsebene 211 angeordnet. Die zweite Metallisierungsebene 211 steht sowohl mit den ersten Kontakten 26 als auch mit den Anschlußleitungen 27 in Verbindung. Die dritten Leitungen 210 und die zweite Metallisierungsebene 211 wird durch Strukturierung einer leitenden Schicht aus Al, Cu, W oder Siliziden in einem gemeinsamen Herstellschritt gebildet.

Die dritten Leitungen 210, die zweiten magnetoresistiven Speicherelemente 29 und die zweite Metallisierungsebene 211 sind von einer dritten Isolationsstruktur 212 umgeben, mit der die dritten Leitungen 210 und die zweite Metallisierungsebene 211 eine planare Oberfläche bilden.

Oberhalb der zweiten Metallisierungsebene 211 sind zweite Kontakte 213 angeordnet, die mit der zweiten Metallisierungsebene 211 in Verbindung stehen. Die zweiten Kontakte 213 sind von einer vierten Isolationsstruktur 214 umgeben, mit der sie eine ebene Oberfläche bilden. Darauf ist eine dritte Metallisierungsebene 215 angeordnet, die von einer fünften Isolationsstruktur 216 umgeben ist, mit der sie eine ebene Oberfläche bildet. In einer Passivierungsschicht 217, die oberhalb der fünften Isolationsstruktur 216 und der dritten Metallisierungsebene 215 angeordnet ist, sind Kontaktlöcher 218 vorgesehen, über die die dritte Metallisierungsebene 215 kontaktierbar ist.

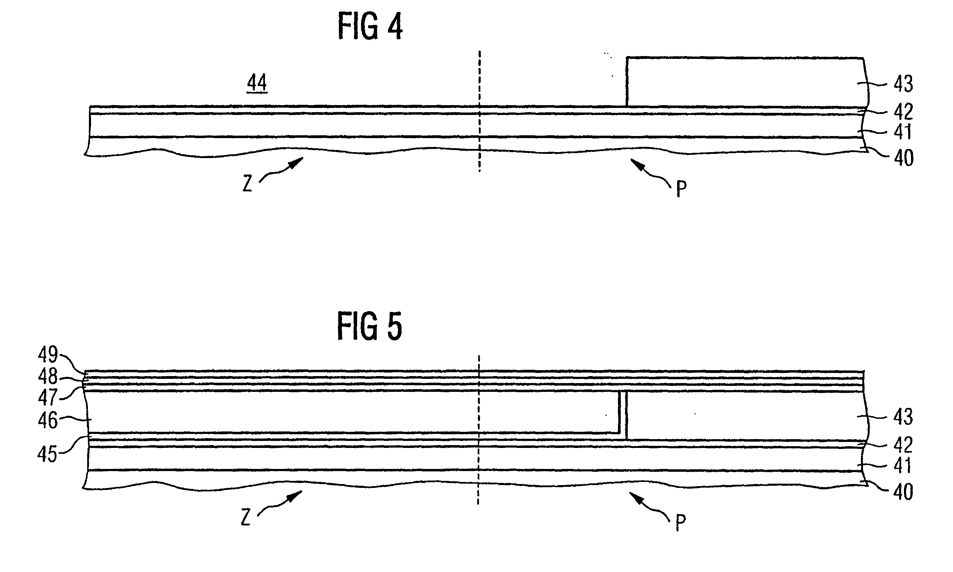

In den Figuren 4 bis 10, anhand denen im folgenden die Herstellung einer Speicherzellenanordnung in einem Dreilagenprozeß erläutert wird, sind ein Zellenfeld Z und eine Peripherie P durch eine gestrichelte senkrechte Linie markiert.

Auf die Oberfläche eines Halbleitersubstrats 40 aus Silizium wird eine erste SiO₂-Schicht 41 in einer Dicke von 50 bis 100 nm, eine erste Si₃N₄-Schicht 42 in einer Dicke von 30 bis 50 nm und eine dritte SiO₂-Schicht 43 in einer Dicke von 400 bis 800 nm aufgebracht (siehe Figur 4). Mit Hilfe einer Lackmaske (nicht dargestellt) und anisotropem Ätzen wird die zweite SiO₂-Schicht 43 strukturiert, so daß die Oberfläche der ersten Si₃N₄-Schicht 42 teilweise freigelegt wird.

Dabei entsteht seitlich der zweiten SiO₂-Schicht 43 ein erster Graben 44. Der erste Graben 44 weist parallel zur Oberfläche des Substrats 40 einen Querschnitt auf, der die Form nachfolgend herzustellender erster Leitungen und einer ersten Metallisierungsebene bestimmt.

Durch Abscheidung einer ersten TaN/Ta-Schicht 45 in einer Dicke von ca. 50 nm und einer ersten Kupferschicht 46 in einer solchen Dicke, daß der erste Graben 44 aufgefüllt wird und anschließendes chemisch mechanisches Polieren bis auf die Oberfläche der zweiten SiO₂-Schicht 43 werden die in den Graben 44 eingebettete erste Leitung und die erste Metallisierungsebene gebildet (siehe Figur 5).

Nachfolgend werden ganzflächig eine erste Barriereschicht 47 aus Ta, Ti, W, Mo oder Nb in einer Dicke von 10 bis 30 nm, eine Schichtenfolge 48 und eine zweite Barriereschicht 49 in einer Dicke von 10 bis 30 nm aus Ta, Ti, W, Mo oder Nb aufgebracht. Die Schichtenfolge 48 enthält eine erste ferromagnetische Schicht mit Co oder Fe, Ni, Cr, Mn, Gd, Dy, eine nichtmagnetische Schicht aus Al₂O₃, NiO, HfO₂, TiO₂, NbO, SiO₂, Cu, Au, Ag oder Al, und eine zweite ferromagnetische Schicht mit NiFe, Co oder Fe, etc. Die Schichtenfolge 48 weist eine Dicke von etwa 10 bis 20 nm auf und ist zur Herstellung von magnetoresistiven Speicherelementen geeignet.

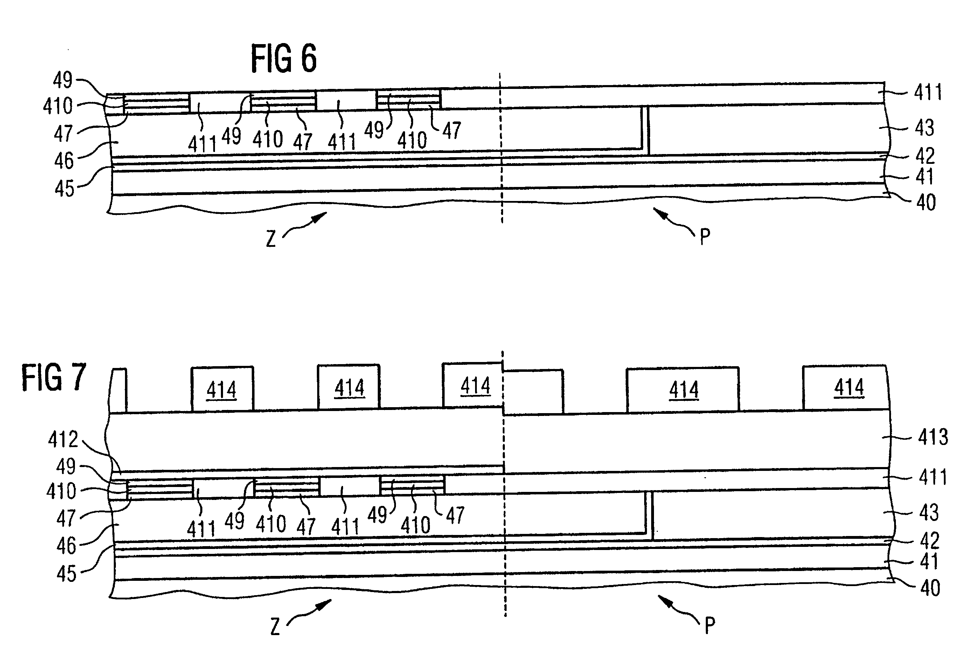

Unter Verwendung einer photolithographisch strukturierten Lackmaske (nicht dargestellt) als Ätzmaske werden die erste Barriereschicht 47, die Schichtenfolge 48 und die zweite Barriereschicht 49 durch anisotropes Ätzen selektiv zu Kupfer und SiO₂ mit Cl- und/oder F-haltigen Ätzgasen strukturiert. Dabei entstehen aus der Schichtenfolge 48 magnetoresistive Speicherelemente, die rasterförmig angeordnet sind (siehe Figur 6).

Nachfolgend wird eine dritte SiO₂-Schicht 411 durch CVD abgeschieden und durch chemisch mechanisches Planarisieren seiektiv zur zweiten Barriereschicht 49 planarisiert. Die dritte SiO₂-Schicht 411 umgibt die magnetoresistiven Speicherelemente seitlich vollständig.

Es wird eine zweite Si₃N₄-Schicht 412 in einer Schichtdicke von 30 bis 50 nm aufgebracht und mit Hilfe einer Photolackmaske (nicht dargestellt) und anisotropem Ätzen mit F-haltigen Ätzgasgemischen (zum Beispiel CF₄/O₂, SF₆/He) strukturiert, so daß die Oberfläche der dritten SiO₂-Schicht 411 im Bereich der Peripherie P freigelegt wird. Die zweite Si₃N₄-Schicht 412 verbleibt somit nur im Bereich des Zellenfeldes Z und bedeckt die zweite Barriereschicht 49 und die dritte SiO₂-Schicht 411 (siehe Figur 7).

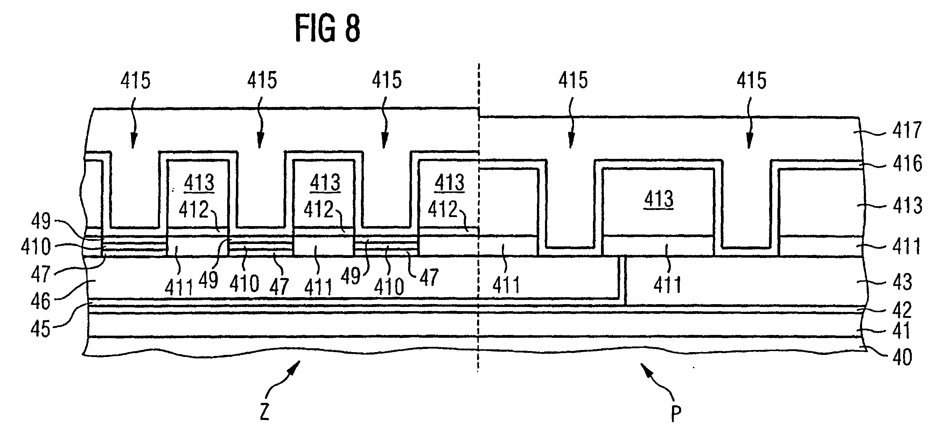

Darauf wird eine vierte SiO₂-Schicht 413 in einer Dicke von 400 bis 800 nm abgeschieden. An der Oberfläche der vierten SiO₂-Schicht 413 wird mit Hilfe photolithographischer Prozeßschritte eine Lackmaske 414 erzeugt, die im Bereich des Zellenfeldes Z zweite Leitungen definiert und im Bereich der Peripherie P die Anordnung von Kontakten. Dabei ist die Oberfläche der vierten SiO₂-Schicht 413 in den Bereichen freigelegt, in denen nachfolgend zweite Leitungen bzw. Kontakte gebildet werden. Durch anisotropes Ätzen selektiv zu Si₃N₄ mit C- und F-haltigen Ätzgasen (zum Beispiel CHF₃/CF₄ oder C₄F₈/CO) unter Verwendung der Lackmaske 414 als Ätzmaske werden die vierte SiO₂-Schicht 413 und die dritte SiO₂-Schicht in der Peripherie P strukturiert. Dabei werden zweite Gräben 415 gebildet. Die zweiten Gräben 415 werden nachfolgend durch Abscheidung einer zweiten TaN/Ta-Schicht 416 in einer Dicke von ca. 50 nm und einer zweiten Kupferschicht 417 in einer Dicke von 300 bis 1000 nm aufgefüllt (siehe Figur 8). Die Mindestdicke der abgeschiedenen zweiten Kupferschicht hängt von der Konformität des Cu-Abscheideprozesses und den Linienbreiten der zu füllenden Gräben ab.

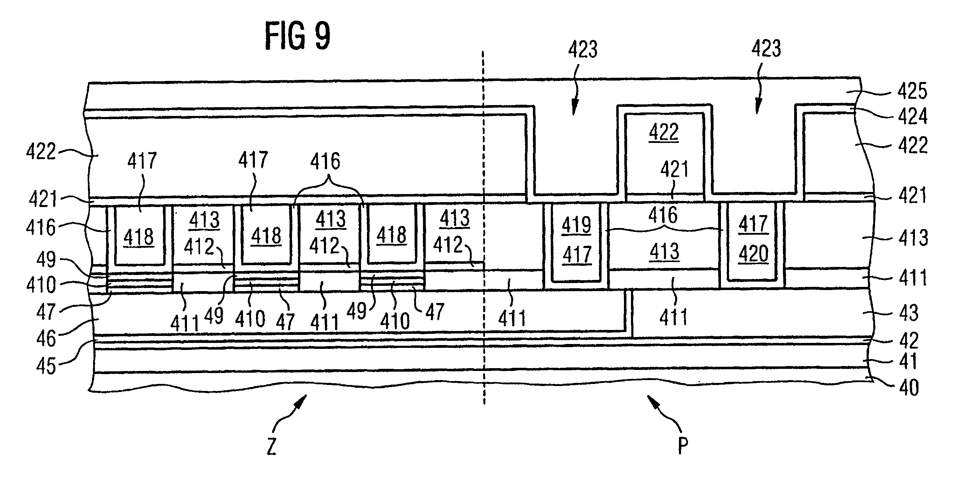

Durch chemisch mechanisches Polieren werden die zweite Kupferschicht 417 und die zweite TaN/Ta-Schicht 416 strukturiert. Dabei werden im Zellenfeld zweite Leitungen 418 und in der Peripherie P Kontakte 419 und Anschlußleitungen 420, die mit den zweiten Leitungen 418 verbunden sind, gebildet (siehe Figur 9).

Es wird ganzflächig eine dritte Si₃N₄-Schicht 421 in einer Dicke von 30 bis 50 nm aufgebracht. Darauf wird eine fünfte SiO₂-Schicht 422 in einer Dicke von 400 bis 800 nm aufgebracht. Unter Verwendung einer photolithographisch erzeugten Lackmaske als Ätzmaske (nicht dargestellt) werden durch anisotropes Ätzen mit C- und F-haltigen Gasen dritte Gräben 423 erzeugt, die mit einer dritten TaN/Ta-Schicht 424 und einer dritten Kupferschicht 425 aufgefüllt werden. Die dritte TaN/Ta-Schicht 424 wird in einer Dicke von ca. 50 nm und die dritte Kupferschicht 425 in einer Dicke von 300 bis 1000 nm abgeschieden.

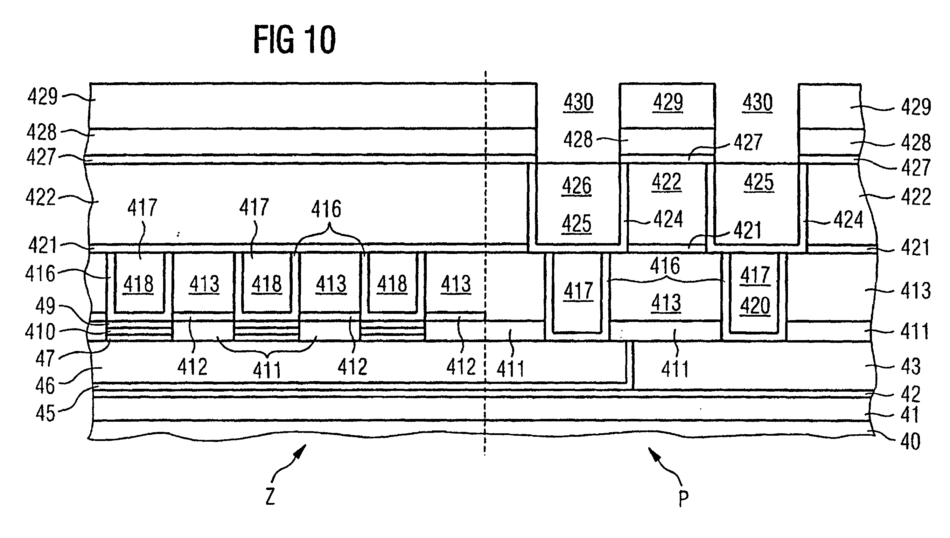

Durch chemisch mechanisches Polieren werden die dritte Kupferschicht 425 und die dritte TaN/Ta-Schicht 424 strukturiert. Dabei wird die Oberfläche der fünften SiO₂-Schicht 422 außerhalb der dritten Gräben 423 freigelegt. In den dritten Gräben 423 wird eine dritte Metallisierungsebene 426 gebildet (siehe Figur 10). Auf die Oberfläche der fünften SiO₂-Schicht 422 und der dritten Metallisierungsebene 426 wird eine Si₃N₄-Schicht 427 in einer Dicke von 50 nm, eine Passivierungsdoppelschicht bestehend aus einer SiO₂-Schicht 428, die in einem Plasma-CVD-Prozeß in einer Dicke von 300 nm erzeugt wird, und einer Si₃N₄-Schicht 429, die in einem Plasma-CVD-Prozeß in einer Dicke von 500 bis 600 nm erzeugt wird, abgeschieden. Mit Hilfe einer photolithographisch erzeugten Maske werden in der Si₃N₄-Schicht 429, der SiO₂-Schicht 428 und der Si₃N₄-Schicht 427 Kontaktlöcher 430 geöffnet, die auf die dritte Metallisierungsebene 426 reichen.

Diese in einen Dreilagenmetallisierungsprozeß integrierte Herstellung einer Speicherzellenanordnung kann vorteilhaft wie folgt modifiziert werden:

Nach Strukturierung der zweiten Barriereschicht 49, der Schichtfolge 48 und der ersten Barriereschicht 47 wird die dritte SiO₂-Schicht 411 durch einen anisotropen RIE-Prozeß (zum Beispiel unter Verwendung C- und F-haltiger Ätzgase) so zurückgeätzt, daß die Speicherelemente durch SiO₂-Spacer lateral isoliert werden. Anschließend wird die zweite Si₃N₄-Schicht 412 möglichst konform abgeschieden. Ohne diese zweite Si₃N₄-Schicht 412 zu strukturieren, wird die vierte SiO₂-Schicht 413 abgeschieden und durch einen kurzen CMP-Schritt planarisiert. Dann werden wie im bereits skizzierten Prozeßablauf die vierte SiO₂-Schicht 413 selektiv zur zweiten Si₃N₄-Schicht 412 und die zweite Si₃N₄-Schicht 412 selektiv zu den SiO₂-Spacern der Schicht 411 und zur zweiten SiO₂-Schicht 43 strukturiert. Alle weiteren Prozeßschritte sind mit denen im bereits skizzierten Prozeßablauf identisch.

Diese Prozeßmodifikation hat folgende Vorteile: Erstens wird eine photolithographische Strukurierungsebene eingespart. Zweitens werden die ersten Leitungen 21 im Zellenfeld Z und in der ersten Metallisierungsebene 22 der Peripherie P durch die Si₃N₄-Schicht 413 vollständig abgedeckt, wodurch in Verbindung mit der ersten TaN/Ta-Schicht 45 eine Ausdiffusion von Cu und anderer beweglicher Elemente (zum Beispiel Ag) aus den ersten Leitungen 21 in die benachbarten SiO₂-Schichten (43, 412) und damit die Degradation dieser Schichten vermindert wird. Drittens wird ein Freilegen der Speicherelementflanken während der Strukturierung der zweiten Gräben 415 und damit ein elektrischer Nebenschluß der Speicherelemente sicher verhindert.

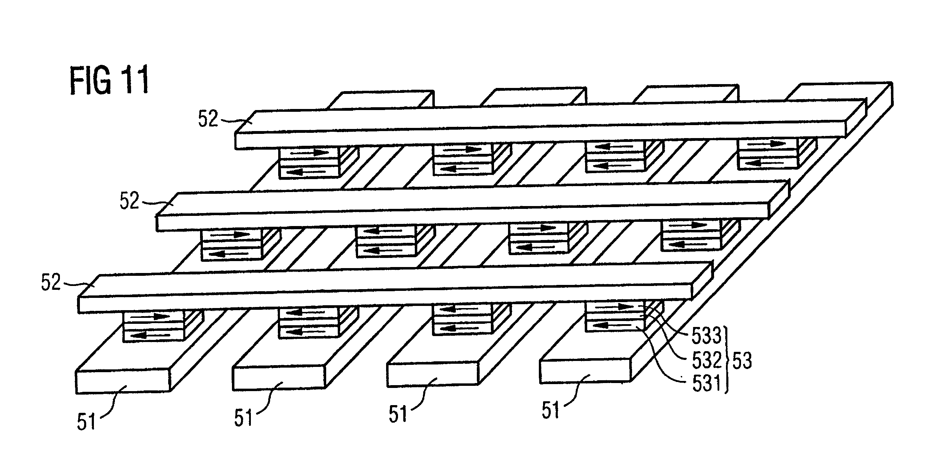

Im Zellenfeld einer Speicherzellenanordnung sind streifenförmige, parallel zueinander verlaufende erste Leitungen 51 und zweite Leitungen 52 angeordnet. Die zweiten Leitungen 52 sind ebenfalls streifenförmig und verlaufen untereinander parallel. Die zweiten Leitungen 52 kreuzen die ersten Leitungen 51. Im Kreuzungsbereich zwischen einer der ersten Leitungen 51 und einer der zweiten Leitungen 52 ist jeweils ein magnetoresistives Speicherelement 53 angeordnet, das eine erste ferromagnetische Schicht 531, eine nichtmagnetische Schicht 532 und eine zweite ferromagnetische Schicht 533 aufweist. Der Querschnitt der magnetoresistiven Speicherelemente 53 ist jeweils rechteckig, langgestreckt sechseckig oder elliptisch. Die lateralen Abmessungen sind vergleichbar mit den Breiten der ersten Leitungen 51 und zweiten Leitungen 52. Die erste ferromagnetische Schicht 531 und die zweite ferromagnetische Schicht 533 weisen eine Dicke von jeweils 3 bis 10 nm auf. Die nichtmagnetische Schicht 532 weist eine Dicke von 1 bis 3 nm auf. Die erste ferromagnetische Schicht 531 enthält Co. Die nichtmagnetische Schicht 532 enthält Al₂O₃. Die zweite ferromagnetische Schicht 533 enthält NiFe. Die ersten Leitungen 51 und die zweiten Leitungen 52 enthalten jeweils Cu (siehe Figur 11).

Der Widerstand der magnetoresistiven Speicherelemente 53 hängt von den Magnetisierungsrichtungen der ersten ferromagnetischen Schicht 531 und der zweiten ferromagnetischen Schicht 533 ab. Bei paralleler Magnetisierung der beiden Schichten zueinander ist der Widerstand kleiner als bei antiparalleler Magnetisierung.

## Patentansprüche

1. Speicherzellenanordnung,
- bei welcher in einem Zellenfeld (Z, Z1, Z2) erste magnetoresistive Speicherelemente (13, 24) vorgesehen sind, die in einer ersten Ebene rasterförmig und jeweils zwischen einer ersten Leitung (11, 21) und einer zweiten Leitung (12, 25) zum Ansprechen der Speicherelemente (13, 24) angeordnet sind, und
- bei welcher in einer Peripherie (P, P1, P2) des Zellenfeldes (Z, Z1, Z2) zur Vertikalkontaktierung desselben mindes-tens eine erste Metallisierungsebene (14, 22), eine zweite Metallisierungsebene (15, 211) und Kontakte (16, 26) vorgesehen sind, wobei durch die Kontakte (16, 26) lokale elektrische Verbindungen zwischen der ersten Metallisierungsebene (14, 22) und der zweiten Metallisierungsebene (15, 211) realisiert werden,
- wobei die ersten Leitungen (11, 21) und die erste Metallisierungsebene (14, 22) in ein und derselben Ebene miteinander kontaktiert angeordnet sind und
- wobei die zweiten Leitungen (12, 25) und die Kontakte (16, 26) in ein und derselben Ebene angeordnet sind.

2. Speicherzellenanordnung nach Anspruch 1,
**dadurch gekennzeichnet,**
- **dass** die ersten Leitungen (11, 21) und die erste Metallisierungsebene (14, 22) im Wesentlichen dieselbe Dicke aufweisen und
- **dass** die zweiten Leitungen (12, 25) und die Kontakte (16, 26) von einem Intermetalldielektrikum (19, 28) umgeben sind und mit dem Intennetalldielektrikum (19, 28) im Wesentlichen in derselben Höhe abschließen.

3. Speicherzellenanordnung nach einem der vorangehenden Ansprüche,
**dadurch gekennzeichnet,**
- **dass** in dem Zellenfeld (Z, Z1, Z2) dritte Leitungen (210) vorgesehen sind, - dass in einer zweiten Ebene zweite magnetoresistive Speicherelemente (29) angeordnet sind, die jeweils zwischen einer der zweiten Leitungen (25) und einer der dritten Leitungen (210) angeordnet sind, und
- **dass** die dritten Leitungen und die zweite Metallisierungsebene in ein und derselben Ebene angeordnet sind.

4. Speicherzellenanordnung nach Anspruch 3,
**dadurch gekennzeichnet,**
- **dass** die dritten Leitungen (210) und die zweite Metallisierungsebene (211) im Wesentlichen dieselbe Dicke aufweisen.

5. Speicherzellenanordnung nach einem der vorangehenden Ansprüche,
**dadurch gekennzeichnet,**
- **dass** die magnetoresistiven Speicherelemente (13, 24, 29) jeweils eine erste ferromagnetische Schicht, eine nichtmagnetische Schicht und eine zweite ferromagnetische Schicht aufweisen,
- **dass** die erste ferromagnetische Schicht und die zweite ferromagnetische Schicht Fe, Ni, Co, Cr, Mn, Gd und/oder Dy enthalten und jeweils eine Dicke im Bereich zwischen 2 nm und 20 nm aufweisen und
- **dass** die nichtmagnetische Schicht Al₂O₃, NiO, HfO₂, TiO₂, NbO, SiO2, Cu, Au, Ag und/oder Al enthält und eine Dicke zwischen 1 nm und 5 nm aufweist.

6. Speicherzellenanordnung nach einem der vorangehenden Ansprüche,
**dadurch gekennzeichnet,**
- **dass** die Leitungen (11, 12, 21, 25, 210) im Zellenfeld Al, Cu, W oder ein Silizid enthalten,
- **dass** zwischen den ersten Leitungen (11, 21) und den ersten magnetoresistiven Speicherelementen (13, 24), den ersten magnetoresistiven Speicherelementen (13, 24) und den zweiten Leitungen (12, 25), den zweiten Leitungen (12, 25) und den zweiten magnetoresistiven Speicherelementen (29) und/oder den zweiten magnetoresistiven Speicherelementen (29) und den dritten Leitungen (210) jeweils eine Diffusionsbarriere vorgesehen ist.

7. Verfahren zur Herstellung einer Speicherzellenanordnung,
**dadurch gekennzeichnet,**
- **dass** auf einer Hauptfläche eines Halbleitersubstrats (10, 20) durch Abscheiden und Strukturieren einer ersten leitenden Schicht in einem Zellenfeld (Z, Z1, Z2) die erste Leitung (11, 21) und in einer Peripherie (P, P1, P2) eine erste Metallisierungsebene (14, 22) erzeugt werden,
- **dass** in dem Zellenfeld (Z, Z1, Z2) erste magnetoresistive Speicherelemente (13, 24) erzeugt werden, die jeweils mit einer der ersten Leitungen (11, 21) verbunden sind,
- **dass** durch Abscheiden und Strukturieren einer zweiten leitenden Schicht im Zellenfeld zweite Leitungen (12, 25), die mit den ersten magnetoresistiven Speicherelementen (13, 24) verbunden sind, und in der Peripherie Kontakte (16, 26), die mit der ersten Metallisierungsebene (14, 22) verbunden sind, gebildet werden,
- **dass** durch Abscheiden und Strukturieren einer dritten leitenden Schicht in der Peripherie eine zweite Metallisierungsebene (15, 211) gebildet wird, die mit den Kontakten (16, 26) verbunden ist.

8. Verfahren nach Anspruch 7, .
**dadurch gekennzeichnet,**
- **dass** auf der Hauptfläche des Halbleitersubstrats (10, 20) eine erste isolierende Schicht (18, 23) erzeugt wird,
- **dass** in der ersten isolierenden Schicht (18, 23) ein erster Graben erzeugt wird, dessen geometrische Form der geometrischen Form der ersten Leitungen (11, 21) und der ersten Metallisierungsebene (14, 22) entspricht,
- **dass** zur Bildung der ersten Leitungen (11, 21) und der ersten Metallisierungsebene (14, 22) die ersten Gräben mit der ersten leitenden Schicht aufgefüllt werden, die planarisiert wird, so dass die Oberfläche der ersten isolierenden Schicht (18, 23) freigelegt wird,
- **dass** nach der Erzeugung der ersten magnetoresistiven Speicherelemente (13, 24) eine zweite isolierende Schicht (19, 28) erzeugt wird, in der zweite Gräben gebildet werden, deren geometrische Form der geometrischen Form der zweiten Leitungen (12, 25) und der Kontakte (16, 26) entspricht,
- **dass** zur Bildung der zweiten Leitungen (12, 25) und der Kontakte (16, 26) die zweiten Gräben mit der zweiten leitenden Schicht aufgefüllt werden, die planarisiert wird, so dass die Oberfläche der zweiten isolierenden Schicht (19, 28) freigelegt wird,
- **dass** eine dritte isolierende Schicht (110, 211) erzeugt wird, in der dritte Gräben gebildet werden, deren geometrische Form der geometrischen Form der zweiten Metallisierungsebene (15, 211) entspricht,
- **dass** zur Bildung der zweiten Metallisierungsebene (15, 211) die dritten Gräben mit der dritten leitenden Schicht aufgefüllt werden, die planarisiert wird, so dass die Oberfläche der dritten isolierenden Schicht (110, 212) freigelegt wird.

9. Verfahren nach Anspruch 7,
**dadurch gekennzeichnet,**
- **dass** nach der bildung der zweiten Leitungen (15, 211) und der Kontakte (16, 26) zweite magnetoresistive Speicherelemente (29) gebildet werden, die jeweils mit einer der zweiten Leitungen (15, 211) verbunden sind,
- **dass** bei der Strukturierung der dritten leitenden Schicht im Zellenfeld (Z, Z1, Z2) zweite Leitungen (15, 211) gebildet werden, die mit den zweiten magnetoresistiven Elementen (29) verbunden sind.

10. Verfahren nach Anspruch 9,
**dadurch gekennzeichnet,**
- **dass** auf der Hauptfläche des Halbleitersubstrats (10, 20) eine erste isolierende Schicht (18, 23) erzeugt wird, in der erste Gräben gebildet werden, deren geometrische Form der geometrischen Form der ersten Leitungen (11, 21) und der ersten Metallisierungsebene (14, 22) entspricht,
- **dass** zur Bildung der ersten Leitungen (11, 21) und der ersten Metallisierungsebene (14, 22) die ersten Gräben mit der ersten leitenden, Schicht aufgefüllt werden, die planarisiert wird, so dass die Oberfläche der ersten isolierenden Schicht (18, 23) freigelegt wird,
- **dass** nach Bildung der ersten magnetoresistiven Elemente (13, 24) eine zweite isolierende Schicht (18, 28) erzeugt wird, in der zweite Gräben erzeugt werden, deren geometrische Form der geometrischen Form der zweiten Leitungen (12, 25) und der Kontakte (16, 26) entspricht,
- **dass** zur Bildung der zweiten Leitungen (12, 25) und der Kontakte (16, 26) die zweiten Gräben mit der zweiten leitenden Schicht aufgefüllt werden, die planarisiert wird, so dass die Oberfläche der zweiten isolierenden Schicht (19, 28) freigelegt wird,
- **dass** nach Bildung der zweiten magnetoresistiven Speicherelemente (29) eine dritte isolierende Schicht (110, 212) erzeugt wird, in der dritte Gräben gebildet werden, deren geometrische Form der geometrischen Form der dritten Leitungen (210) und der zweiten Metallisierungsebene (15, 211) entspricht,
- **dass** zur Bildung der dritten Leitung (210) und der zweiten Metallisierungsebene (15, 211) die dritten Gräben mit der dritten leitenden Schicht aufgefüllt werden, die planarisiert wird, so dass die Oberfläche der dritten isolierenden Schicht (110, 212) freigelegt wird.

## Claims

1. Memory cell arrangement,
- in which first magnetoresistive memory elements (13, 24) are provided in a cell array (Z, Z1, Z2), are arranged in the form of a grid in a first plane and are each arranged between a first line (11, 21) and a second line (12, 25) for addressing the memory elements (13, 24), and
- in which at least one first metallization plane (14, 22), one second metallization plane (15, 211) and contacts (16, 26) are provided in a peripheral area (P, P1, P2) of the cell array (Z, Z1 Z2) in order to make vertical contact with the . latter, wherein local electrical connections are produced between the first metallization plane (14, 22) and the second metallization plane (15, 211) by means of the contacts (16, 26),
- wherein the first lines (11, 21) and the first metallization plane (14, 22) are arranged in one and the same plane such that they make contact with one another, and
- wherein the second lines (12, 25) and the contacts (16, 26) are arranged in one and the same plane.

2. Memory cell arrangement according to Claim 1,
**characterized**
- **in that** the first lines (11, 21) and the first metallization plan (14, 22) have essentially the same thickness, and
- **in that** the second lines (12, 25) and the contacts (16, 26) are surrounded by an intermetal dielectric (19, 28), and terminate essentially at the same level as the intermetal dielectric (19, 28).

3. Memory cell arrangement according to one of the preceding claims,
**characterized**
- **in that** third lines (210) are provided in the cell array (Z, Z1, Z2),
- **in that** second magnetoresistive memory elements (29) are arranged in a second plane and are each arranged between one of the second lines (25) and one of the third lines (210), and
- **in that** the third lines and the second metallization plane are arranged in one and the same plane.

4. Memory cell arrangement according to Claim 3,
**characterized**
- **in that** the third lines (210) and the second metallization plane (211) have essentially the same thickness.

5. Memory cell arrangement according to one of the preceding claims,
**characterized**
- **in that** the magnetoresistive memory elements (13, 24, 29) each have a first ferromagnetic layer, a non-magnetic layer and a second ferromagnetic layer,
- **in that** the first ferromagnetic layer and the second ferromagnetic layer contain Fe, Ni, Co, Cr, Mn, Gd and/or Dy and each have a thickness in the range between 2 nm and 20 nm, and
- **in that** the non-magnetic layer contains Al₂O₃, NiO, HfO₂, TiO₂, NbO, SiO2, Cu, Au, Ag and/or Al and has a thickness of between 1 nm and 5 nm.

6. Memory cell arrangement according to one of the preceding claims,
**characterized**
- **in that** the lines (11, 12, 21, 25, 210) in the cell array contain Al, Cu, W or a silicide, and
- **in that** a diffusion barrier is in each case provided between the first lines (11, 21) and the first magnetoresistive memory elements (13, 24), between the first magnetoresistive memory elements (13, 24) and the second lines (12, 25), between the second lines (12, 25) and the second magnetoresistive memory elements (29) and/or between the second magnetoresistive memory elements (29) and the third lines (210).

7. Method for producing a memory cell arrangement,
**characterized**
- **in that** the first line (11, 21) is produced in a cell array (Z, Z1, Z2) on one main surface of a semiconductor substrate (10, 21) by deposition and structuring of a first conductive layer, and a first metallization plane (14, 22) is produced in a peripheral area (P, P1, P2),
- **in that** first magnetoresistive memory elements (13, 24) are produced in the cell array (Z, Z1, Z2) and are each connected to one of the first lines (11, 21),
- **in that** second lines (12, 25), which are connected to the first magnetoresistive memory elements (13, 24) are formed by deposition and structuring of a second conductive layer in the cell array, and contacts (16, 26) which are connected to the first metallization plane (14, 22) are formed in the peripheral area, and
- **in that** a second metallization plane (15, 211), which is connected to the contacts (16, 26), is formed by deposition and structuring of a third conductive layer in the peripheral area.

8. Method according to Claim 7,
**characterized**
- **in that** a first insulating layer (18, 23) is produced on the main surface of the semiconductor substrate (10, 20),
- **in that** a first trench is produced in the first insulating layer (18, 23) and its geometric shape corresponds to the geometric shape of the first lines (11, 21) and of the first metallization plane (14, 22),
- **in that**, in order to form the first lines (11, 21) and the first metallization plane (14, 22), the first trenches are filled with the first conductive layer, which is planarized such that the surface of the first insulating layer (18, 23) is exposed,
- **in that**, after producing the first magnetoresistive memory elements (13, 24), a second insulating layer (19, 28) is produced, in which second trenches are formed whose geometric shape corresponds to the geometric shape of the second lines (12, 25) and of the contacts (16, 26),
- **in that**, in order to form the second lines (12, 25) and the contacts (16, 26), the second trenches are filled with the second conductive layer, which is planarized such that the surface of the second insulating layer (19, 28) is exposed,
- **in that** a third insulating layer (110, 211) is produced, in which third trenches are formed whose geometric shape corresponds to the geometric shape of the second metallization plane (15, 211), and
- **in that**, in order to form the second metallization plane (15, 211), the third trenches are filled with the third conductive layer, which is planarized such that the surface of the third insulating layer (110, 212) is exposed.

9. Method according to Claim 7,
**characterized**
- **in that**, after forming the second lines (15, 211) and the contacts (16, 26), second magnetoresistive memory elements (29) are formed and are each connected to one of the second lines (15, 211), and
- **in that**, during the structuring of the third conductive layer in the cell array (Z, Z1, Z2), second lines (15, 211) are formed, and are connected to the second magnetoresistive elements (29).

10. Method according to Claim 9,
**characterized**
- **in that** a first insulating layer (18, 23) is produced on the main surface of a semiconductor substrate (10, 20) in which first trenches are formed whose geometric shape corresponds to the geometric shape of the first lines (11, 21) and of the first metallization plane (14, 22),
- **in that**, in order to form the first lines (11, 21) and the first metallization plane (14, 22), the first trenches are filled with the first conductive layer, which is planarized such that the surface of the first insulating layer (18, 23) is exposed,
- **in that**, after forming the first magnetoresistive elements (13, 24), a second insulating layer (18, 28) is produced, in which second trenches are produced whose geometric shape corresponds to the geometric shape of the second lines (12, 25) and of the contacts (16, 26),
- **in that**, in order to form the second lines (12, 25) and the contacts (16, 26), the second trenches are filled with the second conductive layer, which is planarized such that the surface of the second insulating layer (19, 28) is exposed,
- **in that**, after forming the second magnetoresistive memory elements (29), a third insulating layer (110, 212) is produced, in which third trenches are formed whose geometric shape corresponds to the geometric shape of the third lines (210) and of the second metallization plane (15, 211), and
- **in that**, in order to form the third line (210) and the second metallization plane (15, 211), the third trenches are filled with the third conductive layer, which is planarized such that the surface of the third insulating layer (110, 212) is exposed.

## Revendications

1. Dispositif de cellules de mémoire,
- dans lequel il est prévu, dans un champ (Z, Z1, Z2) de cellules, des premiers éléments (13, 24) magnétorésistifs de mémoire qui sont disposés sous forme de trame dans un premier plan et respectivement entre une première ligne (11, 21) et une deuxième ligne (12, 25) pour la stimulation des éléments (13, 24) de mémoire, et
- dans lequel il est prévu à une périphérie (P, P1, P2) du champ (Z, Z1, Z2) de cellules, pour l'établissement d'un contact vertical de celui-ci, au moins un premier plan (14, 22) de métallisation, un deuxième plan (15, 211) de métallisation et des contacts (16, 26), en sorte que par les contacts (16, 26) des liaisons électriques sont réalisées entre le premier plan (14, 22) de métallisation et le deuxième plan (15, 211) de métallisation,
- dans lequel les premières lignes (11, 21) et le premier plan (14, 22) de métallisation sont disposés en étant en contact entre eux dans un seul et même plan et
- dans lequel les deuxièmes lignes (12, 25) et les contacts (16, 26) sont disposés dans un seul et même plan.

2. Dispositif de cellules de mémoire suivant la revendication 1, **caractérisé**
- **en ce que** les premières lignes (11, 21) et le premier plan (14, 22) de métallisation ont sensiblement la même épaisseur et
- **en ce que** les deuxièmes lignes (12, 25) et les contacts (16, 26) sont entourés d'un diélectrique (19, 28) intermétallique et sont en affleurement sensiblement au même niveau avec le diélectrique (19, 28) intermétallique.

3. Dispositif de cellules de mémoire suivant l'une des revendications précédentes, **caractérisé en ce que**
- il est prévu dans le champ (Z, Z1, Z2) de cellules des troisièmes lignes (210),
- **en ce qu'**il est disposé dans un deuxième plan des deuxièmes éléments (29) magnétorésistifs de mémoire qui sont disposés respectivement entre l'une des deuxièmes lignes (25) et l'une des troisièmes lignes (210) et
- **en ce que** les troisièmes lignes et le deuxième plan de métallisation sont disposés dans un seul et même plan.

4. Dispositif de cellules de mémoire suivant la revendication 3, **caractérisé**
- **en ce que** les troisièmes lignes (210) et le deuxième plan (211) de métallisation ont sensiblement la même épaisseur.

5. Dispositif de cellules de mémoire suivant l'une des revendications précédentes, **caractérisé**
- **en ce que** les éléments (13, 24, 29) magnétorésistifs de mémoire ont respectivement une première couche ferromagnétique, une couche non magnétique et une deuxième couche ferromagnétique,
- **en ce que** la première couche ferromagnétique et la deuxième couche ferromagnétique contiennent du Fe, du Ni, du Co, du Cr, du Mn, du Gd et/ou du Dy et ont respectivement une épaisseur de l'ordre de 2 nm à 20 nm et
- **en ce que** la couche non magnétique contient de l'Al₂O₃, du NiO, du HfO₂, du TiO₂, du NbO, du SiO₂, du Cu, de l'Au, de l'Ag et/ou de l'Al et ont une épaisseur comprise entre 1 nm et 5 nm.

6. Dispositif de cellules de mémoire suivant l'une des revendications précédentes, **caractérisé**
- **en ce que** les lignes (11, 12, 21, 25, 210) du champ de cellules contiennent de l'AI, du Cu, du W ou un siliciure,
- **en ce qu'**il est prévu respectivement une barrière de diffusion entre les premières lignes (11, 21) et les premiers éléments (13, 24) magnétorésistifs de mémoire, entre les éléments (13, 24) magnétorésistifs de mémoire et les deuxièmes lignes (12, 25), entre les deuxièmes lignes (12, 25) et les deuxièmes éléments (29) magnétorésistifs de mémoire et/où entre les deuxièmes éléments (29) magnétorésistifs de mémoire et les troisièmes lignes (210).

7. Procédé de production d'un dispositif de cellules de mémoire, **caractérisé**
- **en ce que** l'on produit sur une surface principale d'un substrat (10, 20) semi-conducteur par dépôt et structuration d'une première couche conductrice dans un champ (Z, Z1, Z2) de cellules, la première ligne (11, 21) et à une périphérie (P, P1, P2) un premier plan (14, 22) de métallisation,
- **en ce que** l'on produit dans le champ (Z, Z1, Z2) de cellules de premiers éléments (13, 24) magnétorésistifs de mémoire qui sont reliés respectivement à l'une des premières lignes (11, 21),
- **en ce que**, par dépôt et structuration d'une deuxième couche conductrice, on forme dans le champ de cellules des deuxièmes lignes (12, 25) qui sont reliées aux premiers éléments (13, 24) magnétorésistifs de mémoire et à la périphérie des contacts (16, 26) qui sont reliés au premier plan (14, 22) de métallisation,
- **en ce que**, par dépôt et structuration d'une troisième couche conductrice, on forme à la périphérie un deuxième plan (15, 211) de métallisation qui est relié aux contacts (16, 26).

8. Procédé selon la revendication 7, **caractérisé**
- **en ce que** l'on produit sur la surface principale du substrat (10, 20) semi-conducteur une première couche (18, 23) isolante,
- **en ce que** l'on produit dans la première couche (18, 23) isolante un premier sillon dont la forme géométrique correspond à la forme géométrique des premières lignes (11, 21) et du premier plan (14, 22) de métallisation,
- **en ce que**, pour former les premières lignes (11, 21) et le premier plan (14, 22) de métallisation, on emplit les premiers sillons de la première couche conductrice que l'on planarise de façon à ce que la surface de la première couche (18, 23) isolante soit mise à nu,
- **en ce que**, après la production des premiers éléments (13, 24) magnétorésistifs de mémoire, on produit une deuxième couche (19, 28) isolante dans laquelle sont formés des deuxièmes sillons dont la forme géométrique correspond à la forme géométrique des deuxièmes lignes (12, 25) et des contacts (16, 26),
- **en ce que**, pour la formation des deuxièmes lignes (12, 25) et des contacts (16, 26), on emplit les deuxièmes sillons de la deuxième couche conductrice qui est planarisée, de façon à mettre à nu la surface de la deuxième couche (19, 28) isolante,
- **en ce que** l'on produit une troisième couche (110, 211) isolante dans laquelle sont formés des troisièmes sillons dont la forme géométrique correspond à la forme géométrique du deuxième plan (15, 211) de métallisation,
- **en ce que**, pour former le deuxième plan (15, 211) de métallisation, on emplit les troisièmes sillons de la troisième couche conductrice qui est planarisée, de façon à ce que la surface de la troisième couche (110, 212) isolante soit mise à nu.

9. Procédé suivant la revendication 7, **caractérisé**
- **en ce que**, après la formation des deuxièmes lignes (15, 211) et des contacts (16, 26), on forme des deuxièmes éléments (29) magnétorésistifs de mémoire qui sont reliés respectivement à l'une des deuxièmes lignes (15, 211),
- **en ce que**, lors de la structuration de la troisième couche isolante, on forme dans le champ (Z, Z1, Z2) de cellules des deuxièmes lignes (15, 211) qui sont reliées aux deuxièmes éléments (29) magnétorésistifs.

10. Procédé suivant la revendication 9, **caractérisé**
- **en ce que** l'on produit sur la surface principale du substrat (10, 20) semi-conducteur une première couche (18, 23) isolante dans laquelle il est formé des premiers sillons dont la forme géométrique correspond à la forme géométrique des premières lignes (11, 21) et du premier plan (14, 22) de métallisation,
- **en ce que**, pour former une première ligne (11, 21) et le premier plan (14, 22) de métallisation, on emplit les premiers sillons de la première couche conductrice qui est planarisée de façon à mettre à nu la surface de la première couche (18, 23) isolante,
- **en ce que**, après la formation des premiers éléments (13, 24) magnétorésistifs, on produit une deuxième couche (18, 28) isolante dans laquelle il est produit des deuxièmes sillons dont la forme géométrique correspond à la forme géométrique des deuxièmes lignes (12, 25) et des contacts (16, 26),
- **en ce que**, pour la formation des deuxièmes lignes (12, 25) et des contacts (16, 26), on emplit les deuxièmes sillons de la deuxième couche conductrice qui est planarisée de façon à mettre à nu la surface de la deuxième couche (19, 28) isolante,
- **en ce que**, après formation des deuxièmes éléments (29) magnétorésistifs de mémoire, on produit une troisième couche (110, 212) isolante dans laquelle il est formé des troisièmes sillons dont la forme géométrique correspond à la forme géométrique des troisièmes lignes (210) et du deuxième plan (15, 211) de métallisation,
- **en ce que**, pour la formation de la troisième ligne (210) et du deuxième plan (15, 211) de métallisation, on emplit les troisièmes sillons de la troisième couche conductrice qui est planarisée, de façon à mettre à nu la surface de la troisième couche (110, 212) isolante.
